# EUROPEAN PATENT APPLICATION

(11) **EP 4 637 035 A1**
(43) Date of publication of application: **22.10.2025**
(21) Application number: 24171149.8
(22) Date of filing: 18.04.2024
(51) Int. Cl.: H03K 17/13, H02M 3/335, H03K 17/30

(54) **SYNCHRONOUS RECTIFIER**

(71) Applicant: Collins Aerospace Ireland, Limited, T23 XN53 Cork City (IE)
(72) Inventor: KETZER, Marcos Batista, Ballincollig (IE)
(74) Representative: Dehns

(57) **Abstract**

A synchronous rectifier (140) includes at least a first rectifier switch (141), arranged to switch between an on state and an off state. The synchronous rectifier also includes a controller (150) arranged to output a first control signal for the first rectifier switch (141). The first control signal has a first on trigger and a first off trigger. The controller (150) is arranged to determine the timing of at least one of the first on trigger or the first off trigger based on a reference time point and a first timing offset.

## Description

### Technical Field

This disclosure relates to the design and control of active rectifiers, also known in the industry as synchronous rectifiers.

### Background

Synchronous rectifiers are used to convert an AC voltage to a DC voltage. Advantageously, the active switches used by synchronous rectifiers may provide lower conduction losses than passive diodes. However, they also require accurate control in order to prevent current flowing in the wrong direction through a load attached to the synchronous rectifier, while also maximising the conduction time of the switches.

An electronic control system is required to turn-on and turn-off the rectifier switches at appropriate times. Failure to do this may result in significant losses and even malfunction of the rectifier.

### Summary

The present disclosure provides a synchronous rectifier comprising:
at least a first rectifier switch arranged to switch between an on state and an off state; and
a controller arranged to output a first control signal for the first rectifier switch comprising a first on trigger and a first off trigger;
wherein the controller is arranged to determine the timing of at least one of the first on trigger or the first off trigger based on a reference time point and a first timing offset.

The disclosure provides a synchronous rectifier that is operated so as to allow the timing of the on trigger and/or the off trigger to be adjusted. This may be beneficial to improve the efficiency of the synchronous rectifier.

The controller may be arranged to determine the timing of both the first on trigger and the first off trigger based on a reference time point and a timing offset. The reference time point used by the controller to determine the timing of the first on trigger may be the same as the reference time point used by the controller to determine the timing of the first off trigger. However, in some examples different reference time points may be used. Various of the following features may apply equally to either or both of the first on trigger or the first off trigger.

The first rectifier switch (and optionally also any other rectifier switches) may be a transistor, such as a metal-oxide-semiconductor field-effect transistor (MOSFET), a bipolar junction transistor (BJT), an insulated-gate bipolar transistor (IGBT) or the like. In some examples, the first rectifier switch (and optionally also any other rectifier switches) is a Gallium Nitride (GaN) MOSFET. GaN MOSFETs are particularly well suited to applications that require a relatively fast switching speed. In addition, the voltage drop across GaN devices is higher which means that losses are higher, so the importance of switching timing (to reduce those losses) is increased.

The synchronous rectifier may have any rectifier circuit topology, e.g. a half-bridge rectifier topology, a full-bridge rectifier topology (e.g. comprising an H-bridge), a centre tap rectifier topology (e.g. arranged to be connected to a centre-tap of a transformer's output winding).

The synchronous rectifier may include a second rectifier switch arranged to switch between an on state and an off state. The controller may be arranged to output the first control signal for both the first rectifier switch and the second rectifier switch. In other words, the first rectifier switch and the second rectifier switch may be operated as a first pair.

The synchronous rectifier may include a third rectifier switch and a fourth rectifier switch. The third rectifier switch and the fourth rectifier switch may be similar to the first rectifier switch and the second rectifier switch. The third rectifier switch and the fourth rectifier switch may be operated as a second pair, in a similar manner to the first pair (e.g. using a different reference time point and/or timing offset). The first pair and the second pair may form an H-bridge. Thus, in use, the first pair and the second pair may provide full-wave rectification.

In some examples, the controller is arranged to adjust the first timing offset. For instance, the controller may be arranged to iteratively adjust the first timing offset each rectifier cycle. Adjustment of the first timing offset may enable an improvement of efficiency of the rectifier (e.g. by extending the on-time of the first rectifier switch if the operating conditions allow).

In some examples, the controller is arranged to adjust the first timing offset so as to increase the on time of the first rectifier switch. The timing offset may be adjusted to shift the turn-on point earlier (in the case that the first timing offset is associated with the on trigger) or it may be adjusted to shift the turn-off point later (in the case that the first timing offset is associated with an off trigger).

In some examples, the controller is arranged to detect a voltage across the first rectifier switch at a sampling time based on the reference time point and a second timing offset and is arranged to adjust the first timing offset based on the detected voltage. For instance, the controller may be arranged to detect a voltage across the first rectifier switch immediately before it changes to an on state, and arranged to compare this voltage with a reference voltage to determine whether the first rectifier switch could have been turned on earlier. To provide another example, the controller may be arranged to detect a voltage across the first rectifier switch immediately after it changes to an off state, and arranged to compare this voltage with a reference voltage to determine whether the first rectifier switch could have been turned off later. The synchronous rectifier may comprise a voltage sensor arranged to measure the voltage across the first rectifier switch.

It will be understood that the controller may be arranged to determine the sampling time based on the timing of the at least one of the first on trigger or the first off trigger. For instance, the sampling time may be at a certain (e.g. fixed) offset from the timing of the at least one of the first on trigger or the first off trigger. This approach can be used to ensure that the voltage across the first rectifier switch is sampled immediately before or after the first rectifier switch changes state. As the timing of the at least one of the first on trigger or the first off trigger is determined using the reference time and the first timing offset, such an approach also indirectly determines the sampling time based on the reference time point and a second timing offset as previously described.

In some examples, the first timing offset is determined based on an integration of a difference between the detected voltage and a reference voltage. With such an arrangement, it is possible to fine-tune the first timing offset. Over a plurality of cycles the first timing offset may converge towards a value that is determined by where the detected voltage crosses the reference voltage. The controller may thus comprise an integrator arranged to integrate the difference between the detected voltage and the reference voltage (e.g. over several rectification cycles).

The reference voltage may be selected according to characteristics of the switch. For example, if the switch is a MOSFET with an integrated body diode, the reference voltage may be set approximately equal to a forward bias voltage of the body diode. As another example, if the switch is a GaN MOSFET, the reference voltage may be set approximately equal to a voltage at which third quadrant operation commences. Selection of the reference voltage in this way can provide an indication of whether the switch is conducting before it turns on and/or after it turns off.

In some examples, the controller is arranged determine the sampling time as a time when the first switch is in the off state and adjacent to the transition of the first switch between the on-state and the off-state. For instance, the sampling time may be shortly before the switch transitions to an on-state or shortly after it transitions to an off-state.

In some examples, the synchronous rectifier further comprises a reset circuit arranged to adjust the first timing offset so as to decrease the on time of the first rectifier switch when the reset circuit detects transients. Resetting the first timing offset when the operating conditions change can avoid using a first timing offset that is not valid for the new operating conditions.

The reset circuit may be arranged to detect transients based on the synchronous rectifier's output voltage. For instance, the reset circuit may comprise a filter (e.g. a band-pass filter) arranged to allow frequencies of the output voltage indicative of transient operating conditions to pass through the filter. The synchronous rectifier may be arranged to use the filter's output to adjust the first timing offset.

In some examples, the controller is arranged to output a second control signal for the first rectifier switch comprising a second on trigger and a second off trigger. The second control signal may be provided so as to control the first rectifier switch in a safe manner during transients or as a baseline safe operating mode. The second on trigger may be provided when the voltage across the first rectifier switch crosses a first reference voltage. The second off trigger may be provided when the voltage across the first rectifier switch crosses a second reference voltage. The controller may comprise a second control module (e.g. an analog control module) arranged to provide the second control signal. The second control signal can be designed to prioritise safety and/or robustness (e.g. as opposed to speed and/or efficiency), as the second on and/or second off trigger can be overridden by the first on/off triggers during stable operating periods (i.e. in the absence of transient conditions).

In some examples, the first control signal and the second control signal are combined with OR logic to provide a switch control signal for the first rectifier switch. Thus, the first rectifier switch may be operated in an on state for as long as either of the first control signal or the second control signal allows in order to improve efficiency of the synchronous rectifier. The controller may comprise an OR logic gate or an OR logic function arranged to combine the first control signal and the second control signal.

In some examples, the first control signal is provided by an analog control module of the controller. In some examples, the first control signal is provided by a digital control module of the controller. In other words, the controller may comprise a first control module arranged to provide the first control signal; and this first control module may be a digital control module.

In some examples, the digital control module is arranged to determine the sampling time.

In some examples, the reference time point is determined based on a comparison between the voltage across the first rectifier switch and a first threshold voltage. For instance, the reference time point may be the time at which the voltage across the first rectifier switch changes polarity (e.g. from negative to positive).

In some examples, the controller is arranged to determine:
i) the timing of the first on trigger based on the reference time point and the first timing offset; and
ii) the timing of the first off trigger based on a second reference time point and a third timing offset.

The first and second reference time points may be independent which may improve the control. However, in some examples the first and second reference time points may be the same.

In some examples, the second reference time point is based on the second control signal. More specifically, in certain examples the second reference time point is based on the second off trigger.

In some examples, the controller comprises a timer arranged to reset once per rectification cycle. Thus, the first timing offset may be associated with a certain timer value. The reference time point may also be associated with a certain timer value. The timer may be reset at the same time as the reference time point, or any other point in the rectification cycle.

The present disclosure extends to a voltage converter (e.g. a DC-DC voltage converter) comprising the synchronous rectifier. For instance, the voltage converter could have a LLC or a CLLC voltage converter topology, or any other DC-DC voltage converter topology. The voltage converter may also comprise a switched input stage (e.g. a switched input stage comprising an inverter) and the reference time point may be based on operation of the switched input stage (e.g. based on operation of the inverter). In particular, the reference time point may be based on a control signal to a switch of the inverter.

The present disclosure also provides a method of operating a synchronous rectifier, the synchronous rectifier comprising:
at least a first rectifier switch arranged to switch between an on state and an off state; and
the method comprising:
   outputting a first control signal for the first rectifier switch comprising a first on trigger and a first off trigger; and
   determining the timing of at least one of the first on trigger or the first off trigger based on a reference time point and a first timing offset.

The synchronous rectifier may be the synchronous rectifier according to any of the previously mentioned examples. Thus, any of the optional features of the previously mentioned examples of synchronous rectifiers may apply equally to this method.

In particular, the following features may apply.

In some examples, the method comprises adjusting the first timing offset.

In some examples, the method comprises adjusting the first timing offset so as to increase the on time of the first rectifier switch.

In some examples, the method comprises detecting a voltage across the first rectifier switch at a sampling time based on the reference time point and a second timing offset; and adjusting the first timing offset based on the detected voltage.

In some examples, the method comprises determining the first timing offset based on an integration of a difference between the detected voltage and a reference voltage.

In some examples, the method may comprise selecting the sampling time to be while the first switch is in the off state and adjacent to the transition of the first switch between the on-state and the off-state.

In some examples, the method comprises adjusting the first timing offset so as to decrease the on time of the first rectifier switch when the reset circuit detects transients. For example, the synchronous rectifier may comprise a reset circuit, and this method step may be performed by the reset circuit.

In some examples, the method comprises outputting a second control signal for the first rectifier switch comprising a second on trigger and a second off trigger.

In some examples, the method comprises combining the first control signal and the second control signal with OR logic to provide a switch control signal for the first rectifier switch.

In some examples, the first control signal is provided by a digital control module of the synchronous rectifier (e.g. of a controller of the synchronous rectifier).

In some examples, the method comprises determining the sampling time using the digital control module.

In some examples, the method comprises determining the reference time point based on a comparison between the voltage across the first rectifier switch and a first threshold voltage.

In some examples, the method comprises determining:
i) the timing of the first on trigger based on the reference time point and the first timing offset; and
ii) the timing of the first off trigger based on a second reference time point and a third timing offset.

In some examples, the method comprises resetting a timer once per rectification cycle.

### Brief Description of Drawings

One or more non-limiting examples will now be described, by way of example only, and with reference to the accompanying figures in which:
Figure 1 shows a synchronous rectifier for rectifying an AC input voltage to provide a DC output voltage;
Figure 2 shows waveforms of currents and voltages associated with one known method of operation of the synchronous rectifier shown in Figure 1;
Figure 3 shows a control module of a synchronous rectifier controller shown in Figure 1;
Figure 4 shows a method which outlines how the control module shown in Figure 3 operates in use;
Figure 5 shows the controller of the synchronous rectifier shown in Figure 1;
Figure 6 shows a voltage converter including the synchronous rectifier shown in Figure 1;
Figure 7 shows various waveforms associated with a voltage converter 100 such as the one shown in Figure 6;
Figure 8 shows various waveforms that illustrate how the on trigger and the off trigger may be adjusted using the previously described approaches; and
Figure 9 shows another set of waveforms that illustrate how the on trigger and the off trigger may be adjusted using the previously described approaches.

### Detailed Description

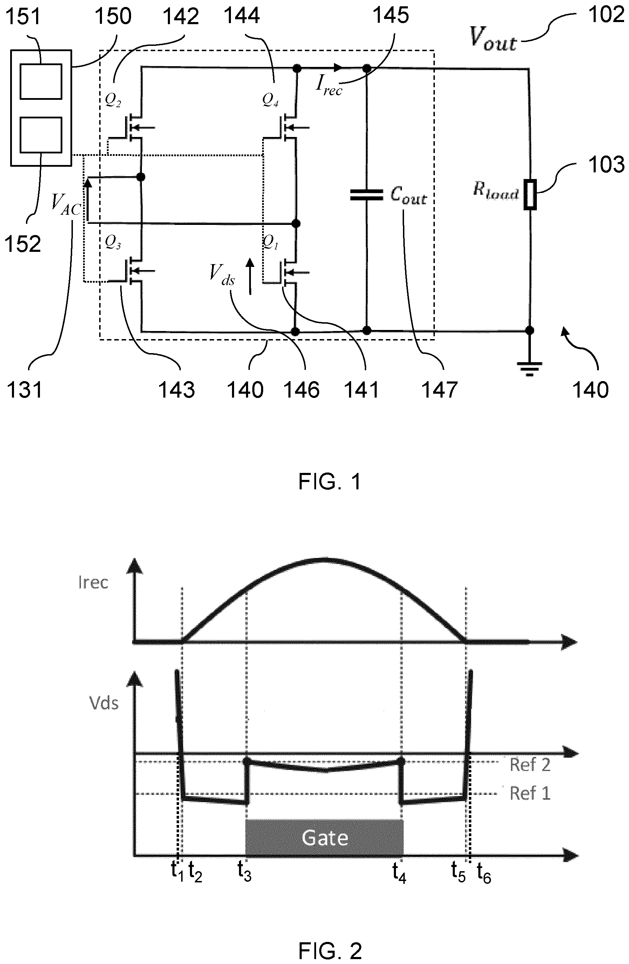

Figure 1 shows a synchronous rectifier 140 for rectifying an AC input voltage V_{AC} 131 to provide a DC output voltage Vₒᵤₜ 102. In use, the output voltage Vₒᵤₜ 102 is applied to an attached load R_{load} 103. In use, the AC input voltage V_{AC} 131 is provided by an attached AC voltage source.

The synchronous rectifier 140 includes a first switch Q₁ 141, a second switch Q₂ 142, a third switch Q₃ 143 and a fourth switch Q₄ 144.

In this example, each of the switches 141, 142, 143, 144 is a MOSFET. More specifically, the MOSFETs 141, 142, 143, 144 shown in Figure 1 are gallium nitride (GaN) MOSFETs. In use, such GaN MOSFETs exhibit diode-like third quadrant operation. These GaN switches 141, 142, 143, 144 can essentially be modelled as a switch arranged in parallel with an antiparallel diode much like the behaviour of a MOSFET with a body diode.

In other examples, the type of switch used may be different. For instance, a switch arranged in parallel with a diode may be used, or other types of MOSFETs (including those that have a switch arranged in parallel with an integrated body diode) may be used.

Each of the switches 141, 142, 143, 144 may be operated in an on-state or an off-state. When in the on state, the switches 141, 142, 143, 144 allow current to flow through the switch 141, 142, 143, 144 in both directions. In the off state the switches 141, 142, 143, 144 prevent current flowing in one direction (e.g. from drain to source), but permit current flow in the opposite direction under certain conditions (e.g. from source to drain either through a diode or other third quadrant operation). A voltage V_{ds} 146 across the first switch Q₁ 141 is labelled in Figure 1.

In combination, the first switch Q₁ 141 and the second switch Q₂ 142 provide a first rectifier current path (through which current flows during a first rectifying phase). In combination, the third switch Q₃ 143 and the fourth switch Q₄ 144 provide a second rectifier current path (through which current flows during a second rectifier phase). The first rectifier current path and the second rectifier current path together form an H-bridge.

In use, current is permitted to flow through either the first rectifier current path or the second rectifier current path, depending on the polarity of the alternating voltage V_{AC} 131, so as to provide full-wave rectification of the alternating voltage V_{AC} 131. The rectified current I_{rec} 145 is shown in Figure 1.

The synchronous rectifier also includes an output capacitor Cₒᵤₜ 147 to filter the rectified current I_{rec} 145. In use, the output capacitor Cₒᵤₜ 147 also provides an energy store, and helps to stabilize the output voltage Vₒᵤₜ 102.

The synchronous rectifier 140 includes a controller 150 for controlling operation of the switches 141, 142, 143, 144. The controller 150 includes a first control module 151 and a second control module 152.

To begin with, operation of the second control module 152 will be explained with reference to Figure 2, which shows waveforms of the rectified current I_{rec} 145 and the voltage V_{ds} 146 across the fist switch 141 for a typical known voltage converter.

Initially, the voltage V_{ds} 146 across the first switch Q₁ 141 is positive. Therefore, the first switch 141 is operated in an off state to prevent current from flowing in the wrong direction through the first rectifier current path.

At time t₁, the voltage V_{ds} 146 crosses zero to become negative.

At time t₂, the voltage V_{ds} 146 reaches a first threshold Ref1. When the voltage V_{ds} 146 is determined to have reached this threshold Ref1, a signal (an on-trigger) is sent to operate the first switch Q₁ 141 and the second switch Q₂ 142 in an on-state, to permit current to flow through the first rectifier current path.

There is a propagation delay between sensing of V_{ds} reaching Ref1 at time t₂, and the first 141 and second Q₂ 142 switches starting to operate in the on-state, at time t₃. This delay may be in part due to excessive delay in the sensing and gate driving circuit. The delay may be in part due to the switch taking time to transition to an on-state after receiving the on-trigger. As previously mentioned, in this example, the first switch Q₁ 141 is a MOSFET. Thus, part of the propagation delay arises from the transistor reaching its threshold voltage at which it can start to conduct.

In this example, the first threshold Ref1 is the same as the voltage at which third quadrant operation is possible, or slightly larger in magnitude, so that crossing of Ref1 is indicative of the first switch conducting in third quadrant operation.

Thus, between t₂ and t₃ current flows through the first switch Q₁ 141 as a result of this third quadrant operation. While this does provide rectification of the AC input voltage V_{AC} 131, the voltage drop across the first switch Q₁ 141 when operating in this mode is relatively high. Therefore, the power loss across the first switch Q₁ 141 is also relatively high during this period.

At time t₃, the first switch Q₁ 141 starts to operate in an on state based on the on trigger. There is then a reduction in the voltage drop across the first switch Q₁ 141 at this time t₃, as the first switch Q₁ 141 provides less resistance in this mode of operation. Therefore, less power is lost across the first switch Q₁ 141.

Between times ta and t₄, the first switch Q₁ 141 continues to operate in an on-state. At t₄, the first switch Q₁ 141 changes to an off state when the voltage V_{ds} 146 across the first switch Q₁ 141 reaches a second threshold Ref 2, before the voltage V_{ds} 146 becomes positive.

While in this example the second threshold Ref 2 is below zero, in other examples a second threshold Ref 2 of zero volts may be used instead.

Between t₄ and t₅, the voltage V_{ds} 146 across the first switch Q₁ 141 is still sufficient for the first switch Q₁ 141 to exhibit diode-like third quadrant behaviour and continue to conduct, thus a current continues to flow through the first rectifier current path. It is desirable to minimise this time period, but at high frequencies, parasitic inductance in the first switch 141 can cause the voltage V_{ds} 146 to reach Ref 2 earlier than desired, thus lengthening this time period and reducing efficiency. At to the voltage V_{ds} 146 becomes insufficient for the first switch Q₁ 141 to continue to conduct, and the current stops flowing. At t₆, the voltage V_{ds} 146 crosses zero to become positive.

The second switch Q₂ 142, the third switch Q₃ 143 and the fourth switch Q₄ 144 are similar to the first switch Q₁ 141.

In use, the voltage V_{ds} 146 across the first switch Q₁ 141 is expected to be approximately the same as the voltage across the second switch Q₂ 142, and they are operated as a first pair. The third switch Q₃ 143 and the fourth switch Q₄ 144 are operated as a second pair, in a similar manner to the first pair. It may be sufficient to monitor V_{ds} 146 for only one switch in a pair, with the other switch of the pair being synchronised with it for simplicity.

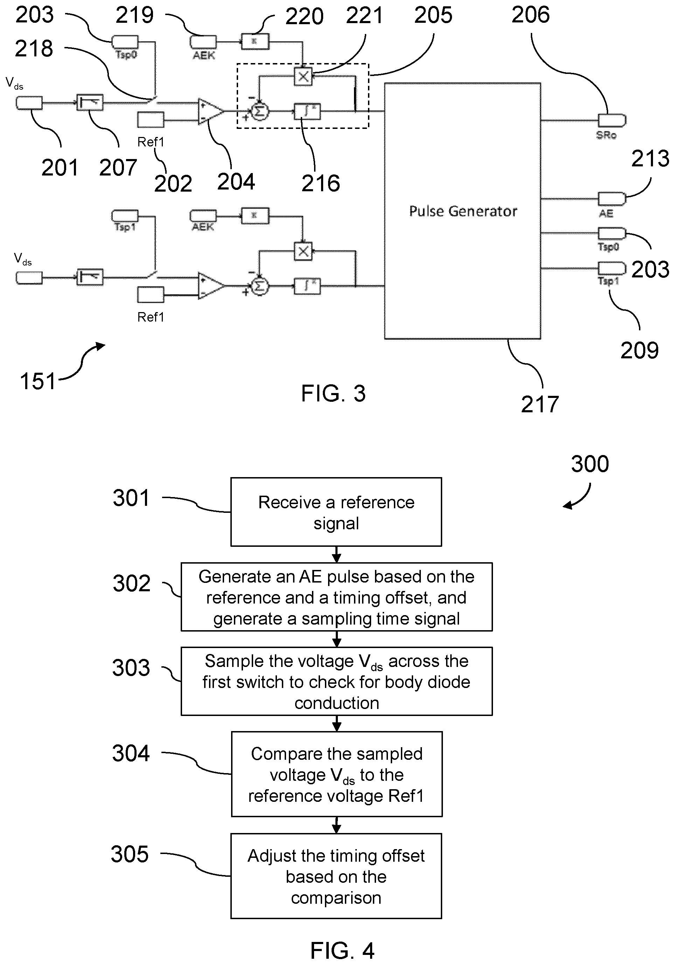

Figure 3 shows an example implementation of the first control module 151 of the controller 150 of Figure 1. The first control module 151 may be used to increase the size of the conduction window of the rectifying switches 141, 142, 143, 144, i.e. the period of time when the switches 141, 142, 143, 144 are operated in an on-state.

The first control module 151 includes a pulse generator 217, arranged to generate an adaptive edge pulse AE 213. As will be described in more detail below, the adaptive edge pulse AE 213 can be used to drive the switch over a longer period of time for greater efficiency.

The start of the adaptive edge pulse AE 213 provides a first on trigger (e.g. in the form of a rising edge) and a first off trigger (e.g. in the form of a falling edge). The pulse generator 217 receives a reference signal SRo 206 which can be used to determine a reference time point. In this example, SRo 206 is generated by the second control module 152, and corresponds to the second control module 152 detecting the voltage V_{ds} 146 across one of the switches 141, 142, 143, 144 (e.g. the first switch Q₁ 141) crossing a certain threshold (e.g. Ref 2 or a zero voltage crossing from negative to positive). In other examples a different reference could be used. The pulse generator 217 generates the on trigger at a first timing offset relative to the reference time point. The off trigger is likewise generated at a further timing offset relative to a reference time point.

The first switch Q₁ 141 and the second switch Q₂ 142 are arranged to switch to an on-state when they receive the adaptive edge pulse AE 213. As previously mentioned, there may be a propagation delay between the receipt of the pulse and the switches starting to conduct, but a large portion of this propagation delay can be cancelled out by adjusting the first timing offset appropriately. Thus, it is possible to decrease the period of time that the switches 141, 142 operate in the third quadrant before switching to an on state, and increase the efficiency of the rectifier. Likewise, by adjusting the timing offset for the off trigger appropriately to increase the duration of the on-state, the effects of parasitic inductances can be cancelled out, again decreasing the period of time that the switching arrangements 141, 142 operate in the third quadrant while in an off state and increasing the efficiency of the rectifier. Thus, the pulse generator 217 provides a dual edge adaptive controller.

In the following description, the switching of the first switch Q₁ 141 will be described, but it will be appreciated that a similar control strategy may be employed for each of the other switches 142, 143, 144.

The pulse generator 217 is also arranged to provide a first sampling signal Tₛₚ₀ 203 and a second sampling signal Tₛₚ₁ 209. The first sampling signal Tₛₚ₀ 203 is generated so as to coincide with a time just before the first switch Q₁ 141 switches on. The second sampling signal Tₛₚ₁ 209 is generated so as to coincide with a time just after the first switch Q₁ 141 switches off.

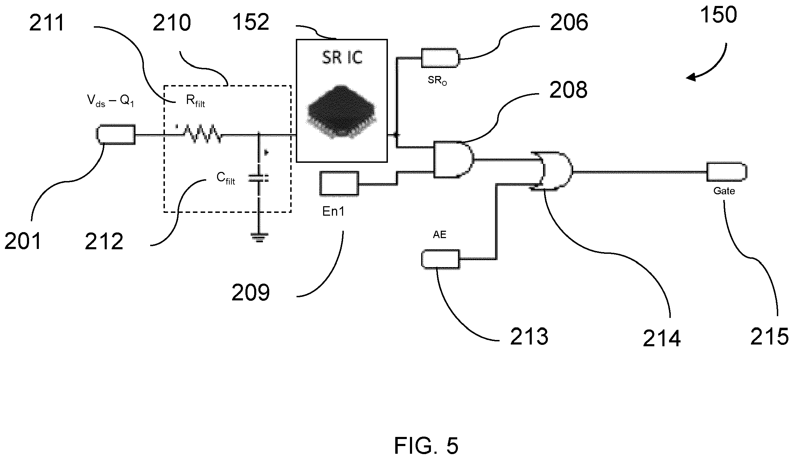

A filter 207 is arranged to filter unwanted components from the voltage V_{ds} 201 across the first switch Q₁ 141. This is a relatively high bandwidth filter 207, e.g. when compared with a filter 210 associated with the second control module 152 (which will be mentioned in the description of Figure 5).

A sampler 218 is arranged to sample the voltage V_{ds} 201 upon receipt of the first sampling signal Tₛₚ₀ 203.

As previously mentioned, the sampling signal Tₛₚ₀ 203 is provided very shortly before the switching on of the first switch Q₁ 141. Purely by way of example, this could be about 50 ns before the switch switches on. Thus, the sampled voltage corresponds to the voltage V_{ds} 201 immediately before t₃ in Figure 2.

A comparator 204 is arranged to compare the sampled voltage with the reference voltage Ref1 202 shown in Figure 2.

If the sampled voltage is less than the reference voltage Ref1, this indicates that the first switch Q₁ 141 was already conducting at the time of the sample and thus the first switch Q₁ 141 could have switched on earlier.

Conversely, if the sampled voltage is greater than the reference voltage Ref1, this indicates that the first switch Q₁ 141 was not conducting at the time of the sample, and thus the first switch Q₁ 141 should not be switched on any earlier.

The output of comparator 204 is provided to integrator 216 which gradually increases in magnitude as subsequent samples of V_{ds} continue to remain below Ref1. Thus, the magnitude of the output from the integrator 216 can be used to determine the first timing offset relative to the reference time point (e.g. relative to the time at which V_{ds} 201 crosses zero from negative to positive). Once the first timing offset has moved the on trigger early enough that the sample (taken before the first switch Q₁ 141 operates in an on-state) is no longer below Ref1, the comparator 204 outputs a signal of opposite sign and the integrator 216 magnitude decreases. At this point, the integrator 216 will hold the first timing offset (and thus the first on trigger) at a time point that minimises the third quadrant operation time.

A feedback loop 205 is arranged to reset the integrator output (and thus the first timing offset and the first on trigger) towards their original values. The feedback loop 205 is driven by the AEK signal 219. This AEK signal is multiplied by a gain K 220 to provide a multiplier factor to a multiplier 221. The multiplier 221 multiplies the integrator output with the multiplier factor and feeds it back to the input. In normal operation the AEK signal 219 is zero so that there is no feedback. However, when transient conditions are detected, the AEK signal becomes non-zero and the magnitude and duration of the AEK signal 219 will cause a rapid reduction in the integrator value, thus quickly resetting the AE signal 213. Once the transient condition has passed, the AEK signal 219 returns to zero and the integrator will gradually build up again with each cycle until the optimal first timing offset is reached once again.

Transients occur when the operating conditions of the synchronous rectifier 140 change. When the operating conditions change, the first control module 151 may require time to determine an appropriate first timing offset for the new operating conditions. The reset functionality of the first control module 151, using the AEK signal 219, ensures that when the operating conditions change, the (previously valid) first timing offset is not used for the new operating conditions, as this first timing offset may no longer be valid. Use of an invalid first timing offset may risk current inversion. Such current inversion can result in high losses, or potentially cause the synchronous rectifier 140 to become unstable. When the first control module 151 resets, control is provided by the second control module 152. The second control module 152 operates in a safe baseline manner (as previously described with reference to Figure 2), without the risk of current inversion.

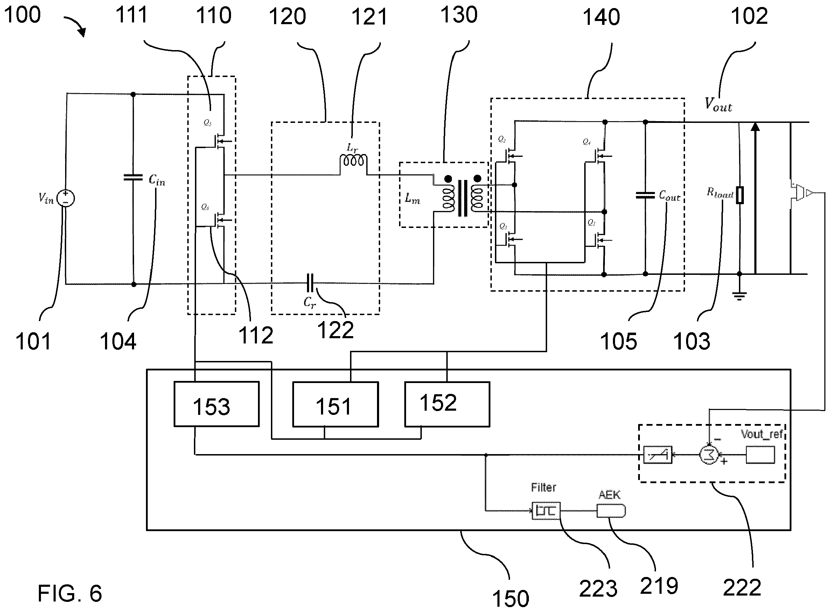

The reset signal AEK 219 may be derived from transient conditions in the rectifier or associated circuitry (e.g. an associated inverter in the case that the rectifier forms part of an LLC converter). In such cases, the magnitude of the reset signal AEK 219 may be dependent on the magnitude of the transient so that a large transient will reset the AE signal 213 faster. Similarly, the duration of the reset signal AEK 219 may be dependent on the duration of the transient so that a longer lasting transient will also reset the AE signal 213 fast, even if it is of low magnitude. An example of a particular approach to transient detection is provided in the description of Figure 6.

Figure 3 also shows a second processing chain that is identical to the processing chain discussed above for the first timing offset, but is shown beneath it and without reference numbers. The main difference is that this second processing chain samples V_{ds} at a second sampling time Tₛₚ₁. The second sampling time is selected to be a short time after the first switch Q₁ 141 switches off. Thus, the second sampling time samples V_{ds} to determine if the first switch Q₁ 141 is conducting (i.e. determining if there is third quadrant operation) after it has transitioned to an off-state. In a similar manner to that described above, if the first switch Q₁ 141 is conducting at this point then it could be turned off later, so the timing offset for the off trigger is increased. If the first switch Q₁ 141 is not conducting at this point, then it should not be turned off any later. The integrator of this second processing arm thus accumulates a value for determining the timing offset for the off trigger over several cycles of the rectifier 140 operation. Once the first off trigger (which is determined from the reference time point and its associated timing offset) has been moved to the latest possible time, the integrator holds it there unless reset by the AEK signal 219. The reference signal (and so the reference time point) for the second processing chain may be the same as for the first processing chain (i.e. the reference signal SRo) or it may be different. In a particular example, the reference signal for the second processing chain may be the off-signal from the second control module 152. This may be a convenient choice of reference signal for extending the on-time of the first switch Q₁ 141 for longer than the second control module 152 would normally operate it in an on-state.

Thus, both the first on trigger and the first off trigger can be moved relative to those of a typical rectifier controller, thus increasing the on time of the first switch Q₁ 141 and thus increasing the efficiency of the rectifier.

The pulse generator 217 may control operation of the third switch Q₃ 143 and the fourth switch Q₄ 144 in addition to the first switch Q₁ 141 and the second switch Q₂ 142. Alternatively, these switches 143, 144 may be controlled by another pulse generator. If two pulse generators are used, it may be easier to operate the first pair (Q₁ 141 and Q₂ 142) and the second pair (Q₃ 143 and Q₄ 144) asymmetrically, to correct for any asymmetries in the circuit. In certain applications, it may be beneficial to force symmetry of the switching times (and thus have a single pulse generator 217).

A method 300 is shown in Figure 3, which outlines how the first control module 151 operates in use.

In a first step 301 of the method 300, the pulse generator 217 receives a reference signal, e.g. the reference signal SRo 206 from the second control module 152, discussed further below (although other reference signals can also be used, examples of which will be mentioned in the description of Figure 6).

In a second step 302, the pulse generator 217 generates the sampling signal Tₛₚ₀ 203 (or Tₛₚ₁) and the adaptive edge pulse AE 203 based on the reference signal and one or more timing offsets. The start of the adaptive edge pulse AE 213 (e.g. the rising edge) can be generated based on a first timing offset and/or the end of the adaptive edge pulse AE 213 (e.g. the falling edge) can be generated based on a third timing offset. The sampling signals Tₛₚ₀ 203 and/or Tₛₚ₁ 209 are generated at a second timing offset and a fourth timing offset respectively, so as to time the sampling of the voltage V_{ds} 201 across the first switch Q₁ 141 just before (for the on trigger) or just after (for the off trigger) it changes state from an off-state to an on-state or vice-versa.

In a third step 303, the sampler 218 samples the voltage V_{ds} 201 across the first switch Q₁ 141 responsive to receiving the sampling signal Tₛₚ₀ 203 (or Tₛₚ₁ 209), shortly before (or shortly after) the first switch Q₁ 141 changes state. The sampled voltage V_{ds} 201 is filtered by the filter 207 to remove unwanted noise from the signal.

In a fourth step 304, the comparator 302 compares the sampled voltage V_{ds} 201 with the reference voltage Ref1.

In a fifth step 305, the timing offset is adjusted based on the comparison of the fourth step 304.

If the sampled voltage V_{ds} across the first switch Q₁ 141 is less than the reference voltage Ref1, the timing offset is adjusted so as to increase the width of the adaptive edge pulse AE 213 (i.e. to increase the on time of the first switch Q₁ 141). Conversely, if the sampled voltage V_{ds} is greater than the reference voltage Ref1, the timing offset is adjusted so as to decrease the width of the adaptive edge pulse AE 213 (i.e. to decrease the on time of the first switch Q₁ 141).

Thus, the method 300 provides an approach for controlling the timing of on/off state changes of the first switch Q₁ 141 to increase the on time by controlling it to switch on earlier and/or controlling it to switch off later, and thus lead to increased efficiency of operation of the synchronous rectifier 140.

The method 300 is an iterative method that repeats for each cycle of the synchronous rectifier 140 so as to refine the timing of the adaptive edge pulse AE 213 over time.

The same approach can be used by the first control module 151 to control operation of the second switch Q₂ 142, the third switch Q₃ 143 and the fourth switch Q₄ 144. In this example, the first Q₁ 141 and second Q₂ switches are operated synchronously as a first pair, and the third Q₃ 143 and fourth Q₄ 144 switches are operated synchronously as a second pair (although it is also possible to operate each switch 141, 142, 143, 144 independently).

This approach works well for relatively steady state operation. For instance, if the frequency and magnitude of the alternating voltage V_{AC} 131 remains relatively constant. However, when transients (e.g. caused by the load or the input voltage source) result in variation of the alternating voltage V_{AC} 131, the expanded on time due to the dual edge adaptive control discussed above, may not include enough error margin. Thus, in some examples the reset mechanism discussed above acts quickly to reduce the on time so as to return to a more robust state of operation. In some examples, the first control module 151 is combined with the second control module 152 to provide a robust controller 150. The second control module 152 outputs a control pulse according to a typical rectifier controller without adaptive edge control, i.e. the on trigger and off trigger are generated when the voltage V_{ds} crosses Ref1 and Ref2 respectively as shown in Fig. 2. The second control module 152 therefore provides a base line control with a minimum efficiency that is at least equal to typical known controllers. When the conditions (e.g. no transients) permit, the first control module 151, i.e. the adaptive edge controller, increases the on time to improve the efficiency over typical known controllers.

Figure 5 shows further details of the controller 150 of Figure 1.

The controller 150 includes an RC filter 210. The RC filter 210 has a resistor R_{filt} 211 and a capacitor C_{filt} 212. The RC filter 210 is arranged to filter out unwanted components of the voltage V_{ds} 201 across the first switch Q₁ 141. The filtered voltage is provided to the second control module 152. Traditionally, there has been a trade-off when designing such RC filters between the bandwidth of the filter 210 and the robustness of the rectifier against abnormal operation; reducing the bandwidth of the filter increases the robustness, but the rectifier will suffer from higher delays and later turn on. Increasing the bandwidth allows for faster operation, but more sensitivity to abnormal operation. However, according to the examples presented in this disclosure, the second control module 152 is primarily used during transients. At other times the first controller module 151 is used. Thus, the use of a more robust, but narrow, RC filter 210 may be acceptable, given that the first control module 151 is primarily used during steady-state operation and overrides the slow responsiveness of the second control module 152.

The second control module 152 is an analogue synchronous rectifier controller 152 and it may be a standard known synchronous rectifier controller of any suitable type. Its operation has previously been described with reference to Figure 2. The second control module 152 may be a discrete (e.g. off-the-shelf) IC, or may have a custom design. The second control module 152 may be a mixed control module with some analog and some digital components. The second control module 152 output (in the form of a switch control pulse) is provided to two devices. Firstly, the output is provided to the pulse generator 217 of the first control module 151, as shown in Figure 3, to provide the reference signal SRo 206.

Secondly, the output is provided to AND gate 208 (discussed below). The start of this pulse coincides with when the voltage V_{ds} 201 across the first switch Q₁ 141 is less than a first threshold Ref1. The end of the pulse coincides with when the voltage V_{ds} 201 is greater than a second threshold Ref2.

In this example, the pulse from the second control module 152 is sent to an AND gate 208. As will be explained in the description of Figure 6, in this example the synchronous rectifier 140 forms part of a voltage converter 100. The voltage converter 100 includes an inverter 110, and the AND gate 208 is also arranged to receive an enable signal En1 based on operation of the inverter 110. The enable signal En1 will be discussed in more detail in the description of Figure 6.

The AND gate 208 is arranged to provide its output to an OR gate 214. The OR gate is also arranged to receive the adaptive edge pulse AE 213 from the previously described pulse generator 217 of the first control module 151. Thus, the first switch Q₁ 141 is operated in an on-state if either the first control module 151 or the second control module 152 provides an on signal. Thus, where conditions permit, the wider signal from the first control module 151 will take precedence and will improve the efficiency, but when it is reset then the second control module 152 ensures a minimum safe conduction period and standard efficiency.

The approach described above for operation of the first switch Q₁ 141 can also be used for the second switch Q₂ 142, the third switch Q₃ 143 and the fourth switch Q₄ 144.

Figure 6 shows a voltage converter 100 for converting an input voltage Vᵢₙ 101 to an output voltage Vₒᵤₜ 102. In use, the input voltage Vᵢₙ 101 is supplied by an attached voltage source, while the output voltage is applied to an attached load R_{load} 103.

The voltage converter 100 includes the synchronous rectifier 140 shown in Figure 1, including the controller 150.

The converter 100 also includes an input capacitor Cᵢₙ 104, an inverter 110, a resonant tank 120 and a transformer 130.

In use, the input capacitor Cᵢₙ 104 buffers the input voltage Vᵢₙ 101.

The inverter 110 has a first inverter switch Q₅ 111 and a second inverter switch Q₆ 112. In this example, the inverter switches 111, 112 are MOSFETs.

The controller 150 may be arranged to operate the inverter switches 111, 112 in addition to the synchronous rectifier switches 141, 142, 143, 144, or a separate controller may be used.

The inverter 110 is arranged to receive the input voltage Vᵢₙ 101. When the first inverter switch Q₅ 111 is operated in a conducting state and the second inverter switch Q₆ 112 is operated in a non-conducting state, the input voltage Vᵢₙ 101 is provided to the resonant tank 120.

When the first inverter switch Q₅ 111 is operated in a non-conducting state and the second inverter switch Q₆ 112 is operated in a conducting state, the input voltage Vᵢₙ 101 is disconnected from the resonant tank 120.

In use, the conduction states of the inverter switches 111, 112 are alternated between the above states, with a brief dead time between them, to provide an alternating square wave voltage as an output from the inverter 110.

The resonant tank 120 includes an inductor Lᵣ 121 and a capacitor Cᵣ 122.

In use, charge oscillates between the inductor Lᵣ 121 and the capacitor Cᵣ 122 at the resonant frequency of the resonant tank 120.

In use, the resonant tank 120 creates an alternating voltage across the primary winding of the transformer 130. This induces a voltage across the secondary winding of the transformer 130, which is the voltage V_{AC} 131 shown in Figure 1. The transformer 130 provides galvanic isolation between the input voltage Vᵢₙ 101 and the output voltage Vₒᵤₜ 102.

The enable signal En1, provided to the AND gate 208 shown in Figure 5, is generally in phase with the voltage across the primary winding of the transformer 130. Hence, using En1 to provide a conduction window of the first switch Q₁ 141 and the second switch Q₂ 142 may help ensure safe operation of the voltage converter 100. A simple implementation of this is for the drive signal for one of the inverter switches 111, 112 to be used as the enable signal En1. The width of En1 may be chosen to be a little larger than half the period associated with the series resonant frequency of the resonant tank 120. In other examples, part of the enable signal, e.g. the start of the enable signal, may be used as the reference time for either, or both, of the on trigger or the off trigger.

In the examples discussed above, the reference signal SRo for determining the reference time point is when the voltage V_{ds} across the first switch Q₁ 141 crosses a certain voltage threshold (e.g. Ref 2 or a zero voltage crossing from negative to positive). However, other examples may use a different reference signal, such as the switch control signal output by the second control module 152. If this switch control signal is used, the reference time point may be determined from any part of that signal, e.g. from the timing of the rising edge or the timing of the falling edge. Alternatively, the switch control signal (for inverter switches 111, 112) from the primary inverter control module 153 can be used as a timing reference.

In some examples, the pulse generator 217 comprises a timer that is reset once per cycle of the rectifier. The reference time point may be determined by reading the timer at an appropriate moment. Likewise, the AE signal 213 may be generated based on the timer by adding or subtracting the relevant timing offsets from the reference time point so as to produce timer values at which the rising and falling edges of the AE signal should be generated. The sampling times Tₛₚ₀ and Tₛₚ₁ may also be generated in the same way.

To provide one example, the timer may be reset upon receiving the reference signal SRo from the second control module 152, to indicate the voltage V_{ds} across the first switch Q₁ 141 crossing from a negative voltage to a positive voltage. The pulse generator 217 generates an on-signal (e.g. the rising edge of the AE signal 213) to operate the first switch Q₁ 141 in an on-state at a first timing offset from receipt of the reference signal SRo. Initially, this timing offset may correspond to a default offset known to be safe for a certain application, or it may correspond to the time at which the on-signal was provided by the second control module 152 on the previous rectifier cycle. The pulse generator 217 also generates a signal for sampling the voltage V_{ds} at a sampling time Tₛₚ₀ shortly before the first switch Q₁ 141 changes to on-state (e.g. 50 ns before) to check whether the first switch Q₁ 141 is conducting before it transitions to an on-state. At a further timing offset, the pulse generator 217 generates an off-signal (e.g. the falling edge of the AE signal 217) to transition the first switch Q₁ 141 to an off-state. Again, initially this may correspond to a default time known to be safe for the application, or the time of the off-signal from the second control module 152 on the previous rectifier cycle. The pulse generator 217 also generates a sampling signal Tₛₚ₁ to sample the voltage V_{ds} shortly after (e.g. 50 ns after) the first switch Q₁ 141 transitions to an off-state to check whether the first switch Q₁ 141 is still conducting. The timing offsets associated with the on trigger and the off trigger are adjusted each cycle of the synchronous rectifier 140, depending on the sampled voltages, to (safely) extend the on-time of the first switch Q₁ 141 and improve efficiency. The times at which the sampling signals are generated are also updated in a corresponding manner.

In other examples, the control signal for operating any one of the inverter switches, e.g. Q₅ 111, may be used to generate the reference signal SRₒ 206 instead, as the time relationship with the rectifier operation is well-defined.

Figure 6 also shows an example of how the AEK reset signal 219 may be generated. In this example, the controller 150 is arranged to operate the voltage converter 100 so as to drive the output voltage Vₒᵤₜ 102 towards a reference output voltage Vout_ref. The controller 150 includes a feedback loop 222 arranged to provide an output based on the difference between the output voltage Vₒᵤₜ 102 and this reference output voltage Vout_ref for adjusting operation of the voltage converter 100 (e.g. the switching frequency or duty cycle of the inverter 110). The inverter switches are controlled by inverter control module 153 which also provides its control signal to the first rectifier control module 151 and the second rectifier control module 152. A band-pass filter 223 is arranged to filter the output of the feedback loop 222, which allows transient frequencies to pass. Thus, in use, the output of the filter 223 provides the AEK signal 219 for resetting the timing offsets.

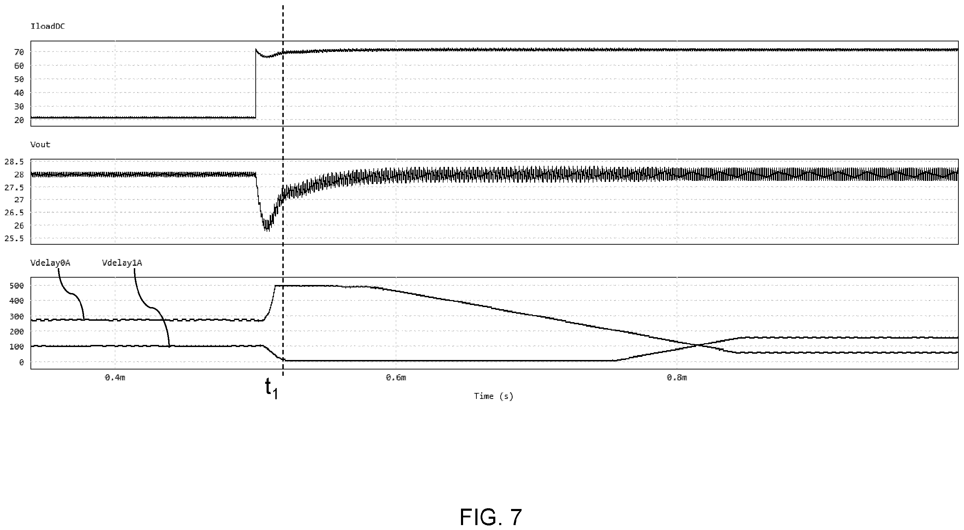

Figure 7 shows various waveforms associated with a voltage converter such as the one shown in Figure 6 for a particular example operation. These include: the current I_{loadDC} through the load R_{load} 103 and the output voltage Vₒᵤₜ 102. These also include a first timing offset V_{delay0A}, which is the delay in nanoseconds between a first time reference and the switching-on of the first switch Q₁ 141 by the first control module 151. In this example, the first reference time is taken from the rising edge of the previously mentioned enable signal En1, which corresponds to the timing of an inverter switch control signal from the inverter control module 153. This switch control signal is also used for controlling the inverter switches Q₅ 111 and/or Q₆ 112. In other examples, a different reference signal could be used, such as the previously described SRo signal that is generated when the voltage V_{ds} across the first switch Q₁ 141 crosses a certain voltage threshold (e.g. Ref 2 or from a negative voltage to a positive voltage). Another timing offset V_{delay1A} is also shown, which is the delay in nanoseconds between a second reference time and the signal for switching-off the first switch Q₁ 141 from the first control module 151. The second reference time in this example is the time at which the voltage V_{ds} across the first switch Q₁ 141 crosses a certain voltage threshold (e.g. Ref 2 or zero volts).

Initially, the first control module 151 operates the first switch Q₁ 141 in an on-state approximately 300 ns after the first reference time (e.g. 300 ns after the rising edge of the inverter switch control signal). The first control module 151 initially operates the first switch Q₁ 141 in an off-state approximately 100 ns after the second reference time (i.e. the timing offset for the off trigger is 100 ns after the voltage V_{ds} crosses the previously mentioned voltage threshold).

As can be seen in the Figure, a transient occurs at time t₁. This causes the reset mechanism to activate and the timing offsets to be reset. This results in a rapid increase in the turn-on delay (the timing offset associated with the on trigger) to 500 ns and a decrease of the turn-off delay (the timing offset associated with the off trigger) to 0 ns (these being known, safe operational values).

Once both delays are reset, the rectifier 140 is initially operated by the second control module 152. Once the transient condition passes, the first control module 151 gradually increases the on-time of the first switch Q₁ 141, by decreasing the timing offset for the on trigger and increasing the timing offset for the off trigger, thereby increasing the on time of the first switch 141. As can be seen, in the new steady-state condition, a timing offset for the on trigger, V_{delay0A} is around 50 ns and a timing offset for the off trigger, V_{delay1A} is around 150 ns.

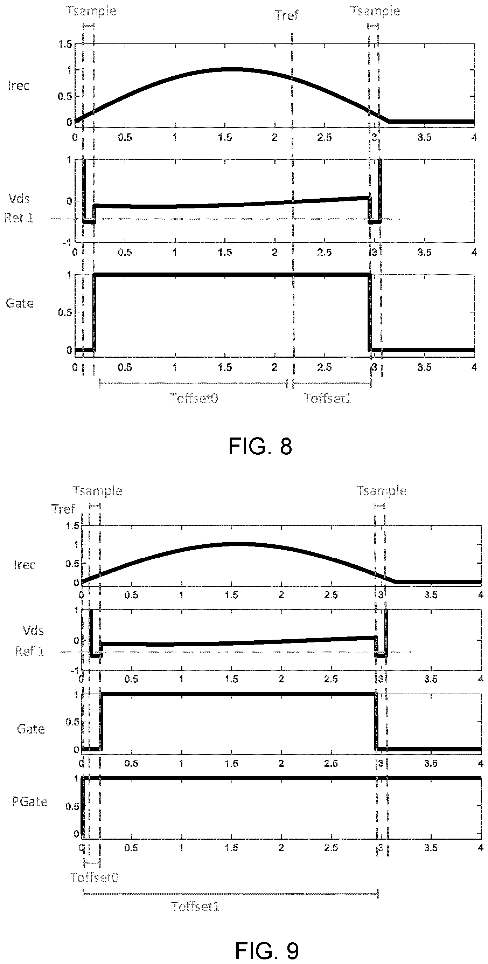

Figure 8 shows various waveforms that illustrate how the on trigger and the off trigger may be adjusted using the previously described approaches. The waveforms shown include the current Irec through a rectifying switch (e.g. the first switch Q₁ 141), the voltage V_{ds} across the rectifying switch and the gate signal Gate to control operation of the rectifying switch (e.g. from the first control module 151). Note that, for simplicity, the on-delay time between gate signal and switch conduction is not shown here.

In Figure 8, the reference time Tref is the time at which the voltage V_{ds} across the rectifying switch crosses from a negative voltage to a positive voltage (i.e. crosses zero volts). The off trigger is generated after a timing offset Toffset1. A sampling signal is generated after a short delay Tsample to sample the voltage across the rectifying switch just after it switches to an off-state (i.e. the timing offset for the sample is Toffset1+Tsample). The sampled voltage is compared with the reference voltage Ref 1, to determine whether the rectifying switch could have remained on for longer (or conversely whether it should have turned off earlier). The timing offset Toffset1 is updated for the next cycle of the rectifier, and the sampling time is also updated accordingly.

Figure 8 also shows a timing offset Toffset0 between the reference time Tref and the timing of the on trigger. In this example, the offset Toffset0 is a negative offset, as the on trigger is generated earlier in the rectification cycle than the reference time (in practice, this can be made into a positive offset by referencing the Tref in a previous cycle). A sampling signal is generated shortly before the on trigger to sample the voltage V_{ds} across the rectifying switch just before it switches to an on-state using another sampling delay Tsample (i.e. the negative timing offset from Vref for this sample is Toffset0+Tsample). This sampled voltage is compared with the reference voltage Ref 1, to determine whether the rectifying switch could have been turned on earlier (or conversely whether it should have turned on later). The timing offset Toffset0 is updated for the next cycle of the rectifier, and the sampling time is also updated accordingly.

The sampling delay used to sample the voltage V_{ds} across the rectifying switch before it switches on may be the same as, or different to, the sampling delay used to sample the voltage V_{ds} across the rectifying switch after it switches off.

Over several cycles, the timing of the on and off triggers will be adjusted so as to increase the on time of the switch. The on trigger will converge towards the time at which the voltage V_{ds} across the rectifying switch first crosses Ref 1 from positive to negative (with the switch in the off state). The off trigger will converge towards the time at which the Voltage V_{ds} crosses Ref 1 from negative to positive (with the switch in the off state). While it may be convenient to use the same reference voltage Ref 1 for both the on and off triggers, different reference voltages could be used for each of the on and off triggers.

Figure 9 shows another set of waveforms that illustrate how the on trigger and the off trigger may be adjusted using the previously described approaches. The waveforms shown include the current Irec through a rectifying switch (e.g. the first switch Q₁ 141), the voltage across the rectifying switch and the gate signal Gate to control operation of the rectifying switch (e.g. from the first control module 151). Also shown is a primary gate signal PGate to control operation of an inverter switch (e.g. the inverter switch Q₅ 111 or the inverter switch Q₆ 112).

Figure 9 is similar to Figure 8. However, in Figure 9 the reference time Tref corresponds to the rising edge of the gate signal PGate for the inverter switch. The on trigger is generated after a timing offset Toffset0. A sampling signal is generated at a short time Tsample before the on trigger to sample the voltage across the rectifying switch just before it switches to an on-state. The sampled voltage is compared with the reference voltage Ref 1 to determine whether the rectifying switch could have been switched on earlier (or conversely whether it should have switched on later). The timing offset Toffset0 is updated for the next cycle of the rectifier, and the sampling time is also updated accordingly.

Figure 9 also shows the generation of the off trigger at another timing offset Toffset1 from the reference time Tref. A sampling signal is generated at a short delay Tsample after the off trigger to sample the voltage across the rectifying switch just after it switches to an off-state. The sampled voltage is compared with the reference voltage Ref 1, to determine whether the rectifying switch could have been switched off later (or conversely whether it should have switched off earlier). The timing offset Toffset1 is updated for the next cycle of the rectifier, and the sampling time is also updated accordingly.

It will be appreciated by those skilled in the art that this disclosure has been illustrated by describing one or more specific examples thereof, but is not limited to these examples; many variations and modifications are possible, within the scope of the accompanying claims.

## Claims

1. A synchronous rectifier comprising:
at least a first rectifier switch arranged to switch between an on state and an off state; and
a controller arranged to output a first control signal for the first rectifier switch comprising a first on trigger and a first off trigger;
wherein the controller is arranged to determine the timing of at least one of the first on trigger or the first off trigger based on a reference time point and a first timing offset.

2. A synchronous rectifier as claimed in claim 1, wherein the controller is arranged to adjust the first timing offset.

3. A synchronous rectifier as claimed in claim 2, wherein the controller is arranged to adjust the first timing offset so as to increase the on time of the first rectifier switch.

4. A synchronous rectifier as claimed in claim 2 or 3, wherein the controller is arranged to detect a voltage across the first rectifier switch at a sampling time based on the reference time point and a second timing offset and is arranged to adjust the first timing offset based on the detected voltage.

5. A synchronous rectifier as claimed in claim 4, wherein the first timing offset is determined based on an integration of a difference between the detected voltage and a reference voltage.

6. A synchronous rectifier as claimed in claim 4 or 5, wherein the controller is arranged to determine the sampling time as a time when the first switch is in the off state and adjacent to the transition of the first switch between the on-state and the off-state.

7. A synchronous rectifier as claimed in any preceding claim, further comprising a reset circuit arranged to adjust the first timing offset so as to decrease the on time of the first rectifier switch when the reset circuit detects transients.

8. A synchronous rectifier as claimed in any preceding claim, wherein the controller is arranged to output a second control signal for the first rectifier switch comprising a second on trigger and a second off trigger.

9. A synchronous rectifier as claimed in claim 8, wherein the first control signal and the second control signal are combined with OR logic to provide a switch control signal for the first rectifier switch.

10. A synchronous rectifier as claimed in any preceding claim, wherein the first control signal is provided by a digital control module of the controller.

11. A synchronous rectifier as claimed in claim 10 and claim 4, wherein the digital control module is arranged to determine the sampling time.

12. A synchronous rectifier as claimed in any preceding claim, wherein the reference time point is determined based on a comparison between the voltage across the first rectifier switch and a first threshold voltage.

13. A synchronous rectifier as claimed in any preceding claim, wherein the controller is arranged to determine:
i) the timing of the first on trigger based on the reference time point and the first timing offset; and
ii) the timing of the first off trigger based on a second reference time point and a third timing offset.

14. A synchronous rectifier as claimed in any preceding claim, wherein the controller comprises a timer arranged to reset once per rectification cycle.

15. A method of operating a synchronous rectifier, the synchronous rectifier comprising:
at least a first rectifier switch arranged to switch between an on state and an off state; and
the method comprising:
outputting a first control signal for the first rectifier switch comprising a first on trigger and a first off trigger; and
determining the timing of at least one of the first on trigger or the first off trigger based on a reference time point and a first timing offset.
